# EUROPEAN PATENT SPECIFICATION

(11) **EP 0 720 123 B1**
(45) Date of publication and mention of the grant of the patent: **19.03.2003**
(21) Application number: 95120242.3
(22) Date of filing: 21.12.1995
(51) Int. Cl.: G06K 19/077

(54) **Non-contact type IC card and method and apparatus for manufacturing the same**
Kontaktlose Chipkarte und Verfahren und Vorrichtung zu ihrer Herstellung
Carte à puce du type sans contact et méthode et appareil de fabrication

(30) Priority: 27.12.1994 JP 32545494; 20.12.1995 JP 33197795
(43) Date of publication of application: 03.07.1996
(60) Divisional application: 01116097.5
(73) Proprietor: MITSUBISHI DENKI KABUSHIKI KAISHA, Tokyo 100 (JP)
(72) Inventor: Takahira, Kenichi, Chiyoda-ku, Tokyo 100 (JP); Ohbuchi, Jun, Chiyoda-ku, Tokyo 100 (JP); Murasawa, Yasuhiro, Chiyoda-ku, Tokyo 100 (JP)
(74) Representative: Leson, Thomas Johannes Alois, Dipl.-Ing.

(56) References cited:
- EP-A- 0 481 776
- FR-A- 2 695 594

## Description

### BACKGROUND OF THE INVENTION

### FIELD OF THE INVENTION

The present invention relates to a non-contact type IC card and circuit board and to a method and apparatus for manufacturing a non-contact type IC card.

### DESCRIPTION OF THE RELATED ART

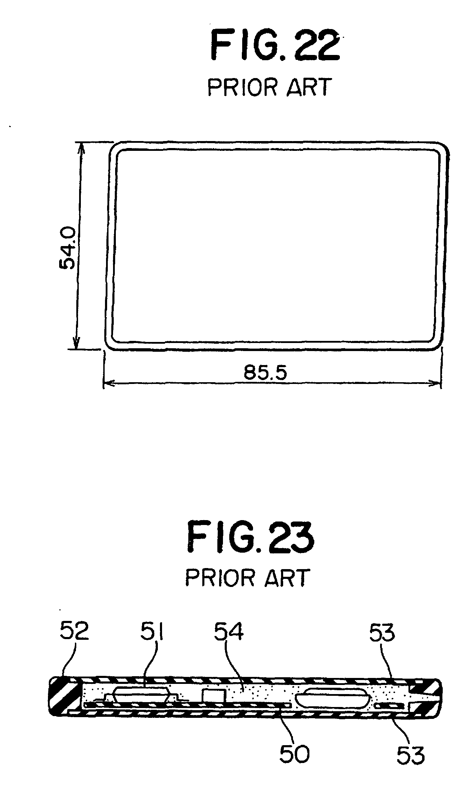

Figs.22 and 23 are a front view and a sectional view, respectively, of a known non-contact type IC card. In a known structure for non-contact type IC card, a functional circuit part referred to as a module obtained by mounting electronic parts 51 on a circuit board 50 of a glass epoxy is put into a card-shaped plastic frame 52 which is filled with a resin 54 or the like while the surfaces of the card are sandwiched by plastic panels 53.

As disclosed in Japanese Patent Laid-Open No.2-212197, a technique has been provided as a method for manufacturing a non-contact type IC card in which a circuit board is constituted by a synthetic resin film and a circuit pattern is formed thereon by printing a conductive paste or by pressure-bonding a conductor foil by a heat treatment using a press.

A demand has arisen in recent years to reduce thickness of the card to the same level as a magnetic card of about 0.8 mm while at the same time reducing the cost of the card.

Fig.24 is a sectional view of a circuit board of another conventional IC card. In this conventional IC card, the circuit board is constructed such that a circuit pattern 101 is formed by etching a copper foil on a circuit board 102 which is made of an epoxy resin or phenobresin or the like. Further, as shown in Fig.25, the circuit pattern 101 in some cases is formed on the both principal surfaces *of* the circuit board 102. For the electric conduction between the circuit patterns 101 formed on the respective surfaces, a plating 103 covering and associating two conductive lands 101a is applied as shown in Fig.26 to an inner circumferential surface of a hole which is provided through the conductive lands 101a to effect an electric conduction.

FR-A-2 695 594 and EP 0 481 776 A2 disclose generic non-contact type IC cards comprising a first sheet made of a resin having one surface defining an outer sheath of the IC card; a circuit pattern device including a conductive circuit pattern provided on the other surface of said first sheet; electronic parts mounted on said circuit pattern device; and an electrically insulating filling resin material for filling a gap.

It is an object of the present invention to provide a non-contact IC card, a method and an apparatus for manufacturing the same capable of being manufactured under automatization with fewer manufacturing steps and shorter manufacturing time, and furthermore to provide an IC card having an improved strength.

This object is solved by the non-contact type IC card according to claim 1, the method for manufacturing the same according to claim 8 and the apparatus for manufacturing the same according to claim 18. The invention is further developed according to the subclaims. The claims are delimited against FR-A-2 695 594.

### BRIEF DESCRIPTION OF THE DRAWING

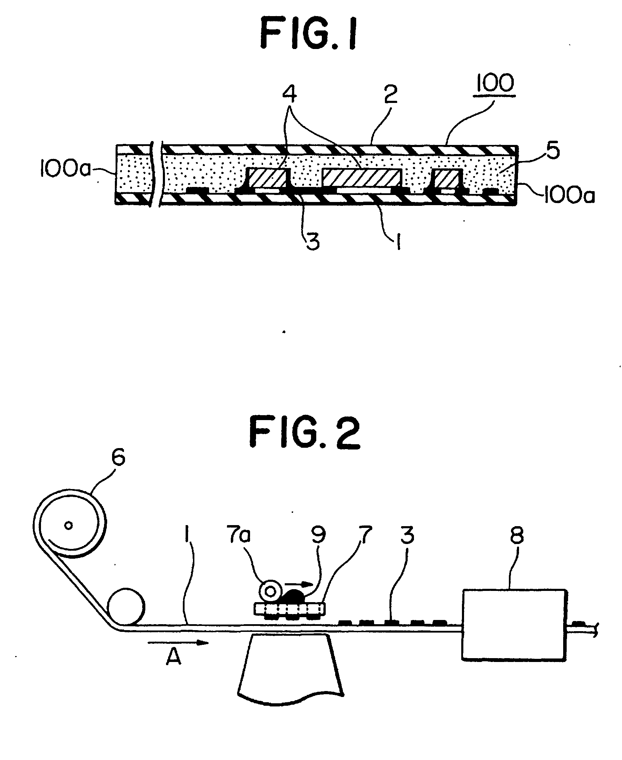

Fig.1 is a sectional view of a non-contact type IC card according to an comparative example.
Fig.2 shows a device including a circuit pattern device forming device.

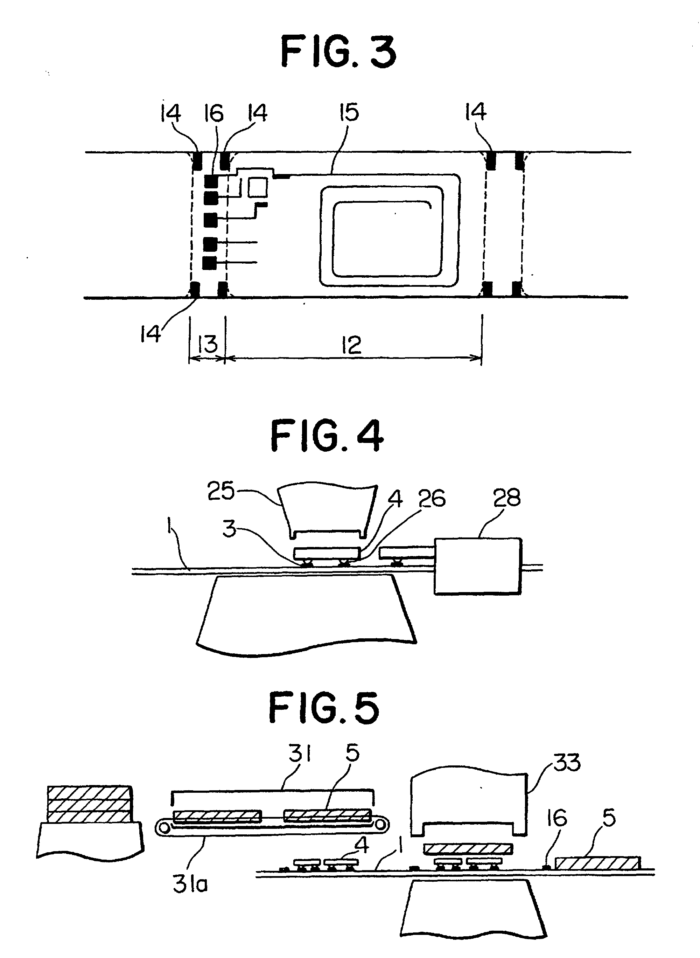

Fig.3 is a front view of a sheet printed on the circuit pattern.
Fig.4 shows an electronic part mounting device including a chip mounter.
Fig.5 shows a plastic material compressing device including a heater and a press.

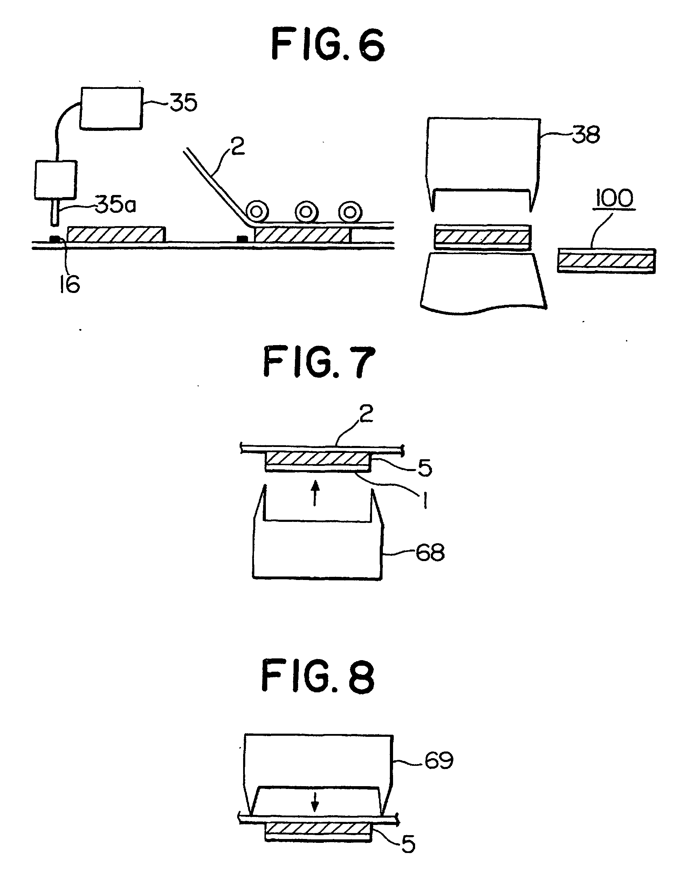

Fig.6 shows a checking device including a circuit tester and severing device including a cutter.
Fig.7 shows the manner of cutting off by a cutter starting from the bottom in the severing step.
Fig.8 shows the manner of cutting off by a cutter starting from the top in the severing step.

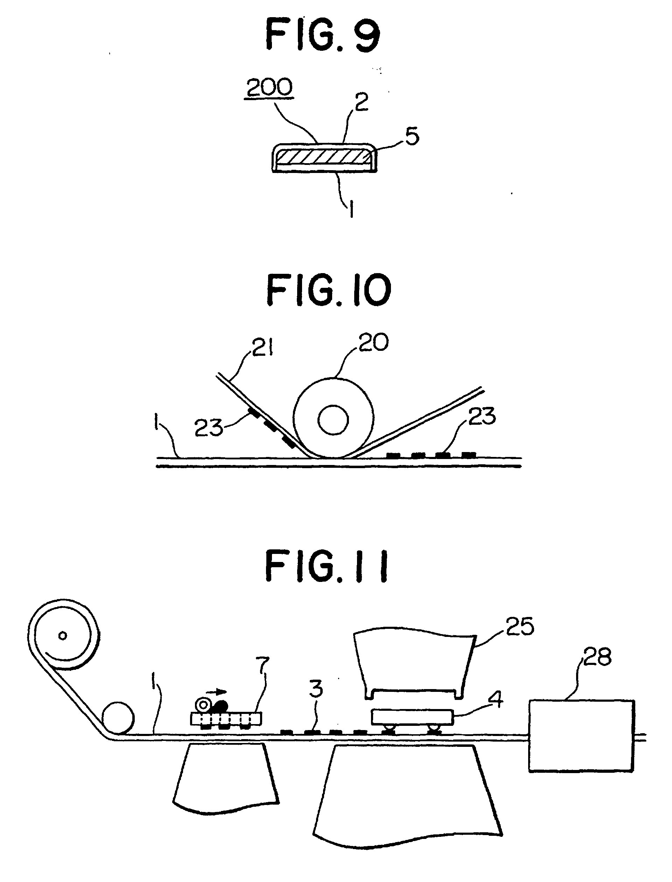

Fig.9 is a sectional view of the non-contact type IC card severed by the cutter as shown in Figs.7 and 8.
Fig.10 shows a circuit pattern device forming device which is another comparative example of the non-contact type IC card manufacturing apparatus.
Fig.11 shows an apparatus obliterating a curing drying furnace after the circuit pattern forming step which is another comparative example of the non-contact type IC card manufacturing apparatus.

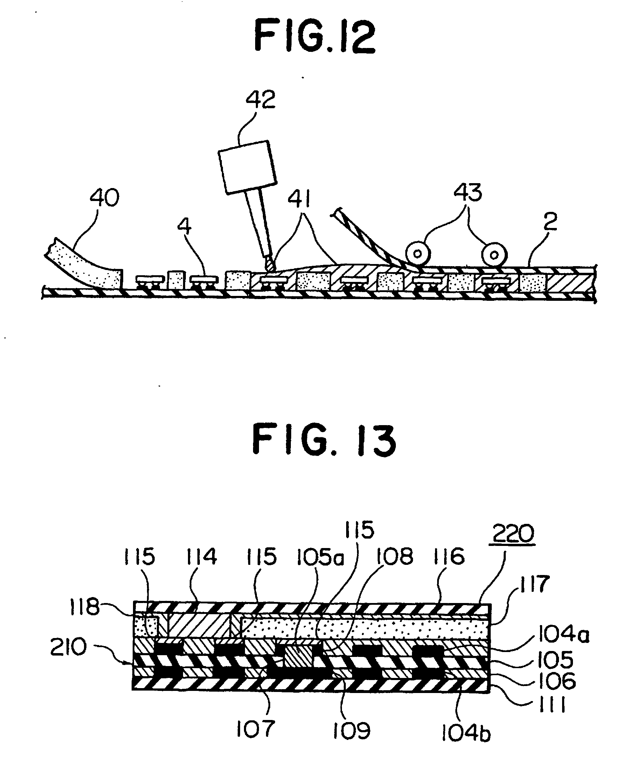

Fig.12 shows a method for manufacturing a non-contact type IC card using an intermediate layer which is an embodiment of the non-contact type IC card manufacturing apparatus according to the invention.
Fig.13 is a sectional view showing another comparative example of non-contact type IC card.

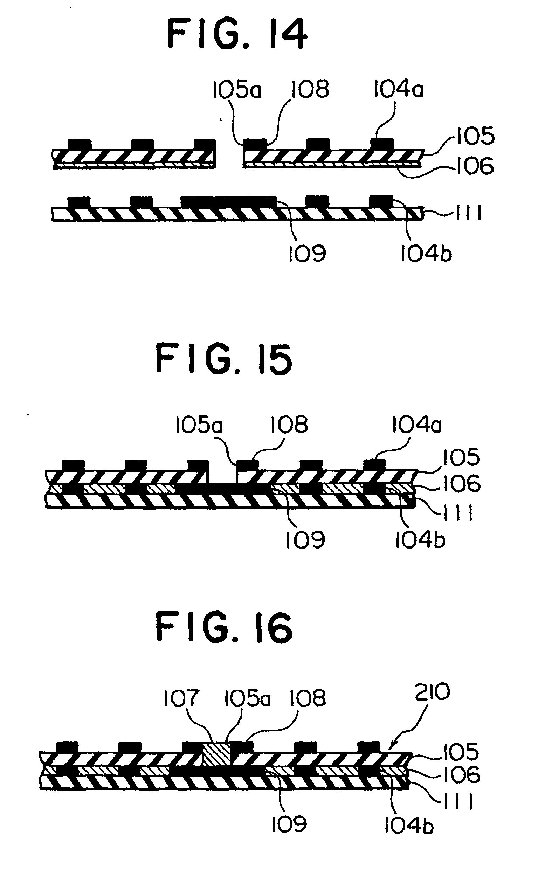

Fig.14 shows the manufacturing process of a non-contact type IC card in accordance with the sequence of the process.
Fig.15 shows the manufacturing process of a non-contact type IC card in accordance with the sequence of the process.
Fig.16 shows the manufacturing process of a non-contact type IC card in accordance with the sequence of the process.

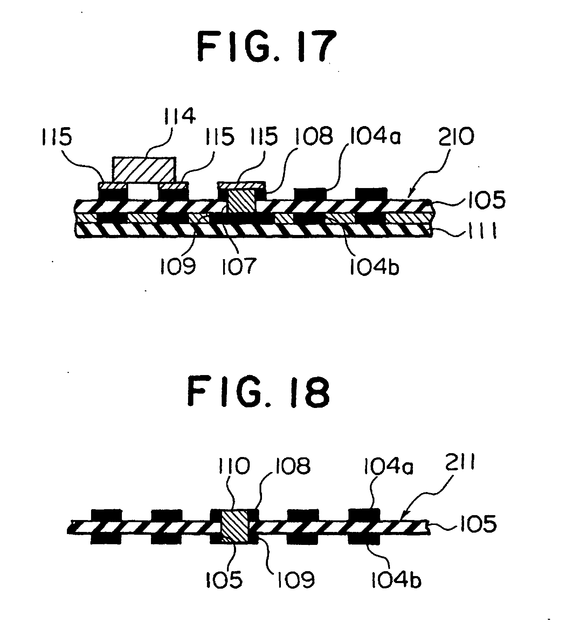

Fig.17 shows the manufacturing process of a non-contact type IC card in accordance with the sequence of the process.
Fig.18 is a sectional view of a circuit board showing another comparative example of the non-contact type IC card.

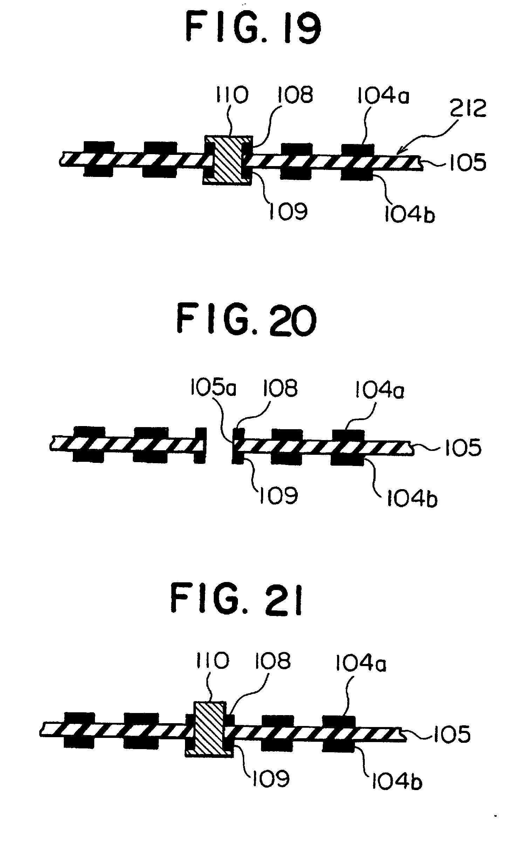

Fig.19 is a sectional view of a circuit board showing another comparative example of the non-contact type IC card.
Fig.20 shows the manufacturing process of a circuit board in accordance with the sequence of the process.
Fig.21 shows the manufacturing process of a circuit board in accordance with the sequence of the process.
Fig.22 is a plan view of a known non-contact type IC card.
Fig.23 is a side sectional view of a known non-contact type IC card.

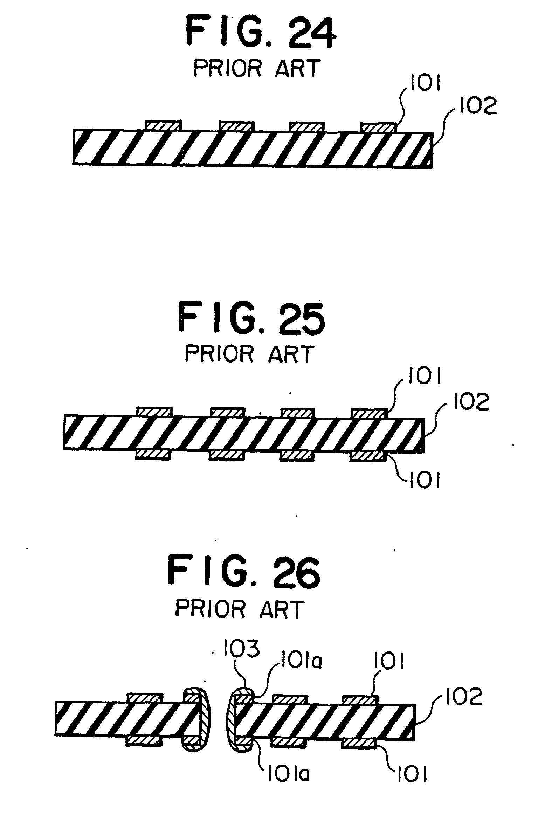

Fig.24 is a sectional view of a circuit board showing another comparative example of a known non-contact type IC card.
Fig.25 is a sectional view of a circuit board showing another comparative example of a known non-contact type IC card.
Fig.26 is a sectional view of a circuit board showing another comparative example of a known non-contact type IC card.

### DESCRIPTION OF THE PREFERRED EMBODIMENTS

The present description also gives comparative examples which are no embodiments of the invention, but given for illustrative purposes only.

### Comparative example 1

A non-contact type IC card 100 according to an comparative example as shown in Fig.1 has a sheet 1 made of a resin of which one surface is exposed to form an armor or an outer sheath for a lower surface of the IC card, and a circuit pattern 3 serving as a circuit pattern device is formed on an upper surface of the sheet 1. Electronic parts 4 are mounted on the circuit pattern 3 as electrically connected thereto. Disposed on the upper surface of the sheet 1 is a plastic material 5 which completely covers the circuit pattern 3 and the electronic parts 4 and is plastically deformed into the shape of a flat plate by a press. Adhered furthermore onto the upper surface of the plastic material 5 is an. outer sheath sheet 2 of the same material as the sheet 1. Further, the four side surfaces 100a of the IC card 100 are cut off by a cutting edge to form an IC card having a standard shape.

The sheet 1 and sheet 2 are constituted by PET (polyethylene terephthalate) material or by sheets of materials of the same type. Further, the plastic material 5 is constituted by a thermoplastic prepreg material (such as WIP PP/GF) having an electric insulating characteristic.

A method for producing the non-contact type IC card 100 constructed as the above will now be described. Fig.2 shows a system including a screen printing machine 7 serving as a circuit pattern device forming device which is a part of the apparatus for manufacturing the non-contact type IC card 100. The sheet 1 is formed as a strip having a thickness of the order of 0.1 to 0.2 mm and is wound into the manner of a roll 6. The sheet 1 in the state of the roll 6 is sequentially fed in the direction of arrow A toward the screen printing machine 7.

The screen printing machine 7 serving as the circuit pattern device forming device forms the circuit pattern 3 on the sheet 1 by pushing out a conductive ink or conductive paste 9 (such as silver or carbon) by means of a roller 7a. The apparatus is constructed so that the sheet 1 with a screen printing effected thereon is dried and cured in a drying furnace 8 and is then sent to a next processing step.

Fig.3 is a front view of the sheet 1 with a circuit pattern 3 printed thereon. The sheet 1 is generally divided into: a mount area 12 which is a portion to be mounted on the card with the circuit pattern 3 consisting of an antenna 15, etc., being printed thereon; and a testing area 13 having a test electrode 16 printed thereon to be cut off at a later step. Identification marks 14 are printed respectively at boundary portions for the purpose of positioning in the severing step to be performed later.

Fig.4 shows an electronic part mounting device which is a part of the apparatus for manufacturing the non-contact type IC card 100 and includes a chip mounter 25. What is performed here is the step of mounting the electronic parts 4 on the circuit pattern 3 which follows the circuit pattern forming step of Fig.2. The electronic parts 4 are mounted at predetermined positions on the circuit pattern 3 by the chip mounter 25. Here, connection of bumps 26 which are the electrodes for the electronic parts 4 is possible by previously applying a conductive adhesive on the bumps 26. Drying and curing are effected thereafter in a curing drying furnace 28.

Fig.5 shows a plastic material compressing device which is a part of the apparatus for manufacturing the non-contact type IC card 100 and includes a heater 31 and a press 33. The plastic material 5 is provided as having substantially the same size as the IC card and receives a heat from the heater 31 (about 200C) to be softened. The plastic material 5 is supplied to a position over the circuit pattern 3 and electronic parts 4 of the sheet 1 by a conveyor 31a or the like which is moved in synchronization with the travelling of the sheet 1, and it is subjected to a stamping by the press 33 so as to be plastically deformed in a manner completely covering the electronic parts 4 which are mounted on the sheet 1. Since the plastic material 5 is being softened by a heat, it is plastically deformed by a pressure from the press 33 and reaches the circuit pattern 3 to be formed into a predetermined thickness while filling the gap between the electronic parts 4. The plastic material 5 and the sheet 1 are adhered to each other by means of a compression and at this point, the plastic material 5 has substantially the size of the IC card 100. At this time, the test terminal 16 is exposed without being covered by the plastic material 5.

Fig.6 shows a checking device-including a circuit tester and a severing device including a cutter which constitute a part of the apparatus for manufacturing the non-contact type IC card 100. As shown in Fig.6, a test head 35a of the circuit tester 35 is brought into contact with the exposed test terminal 16 to check the circuit function. Thereafter, positioning is effected by the identification marks 14 on the sheet 1 and the outer sheath sheet 2 is adhered to the card surface. Cutting off into the shape of a card is then effected by the cutter 38 which is designed to have the size of a card. The severing is effected so that the cut surfaces are perpendicular to the main surface of the IC card in the form of a plate and the plastic material 5 is exposed. Although the cut surface of the test terminal 16 is also exposed, it causes no problem in using the IC card because it is very thin.

It should be noted that such as the following method may be used to prevent the cut surface of the plastic material 5 and test terminal 16 from being exposed on an end surface of the card. As shown in Figs.7 and 8, the edge of the cutter is penetrated in two steps when effecting the severance. First, severing of only the sheet 1 and plastic material 5 is effected starting from the bottom of the IC card by a first cutter 68 which is somewhat smaller than the shape of the card. Next, by effecting a severance starting from the top by a second cutter 69 which is - somewhat larger than the shape of the card, the outer sheath sheet 2 is cut off while being curved to contain the plastic material 5 at the end surface of the IC card so as to form an outer sheath for the side surface of the IC card 200 when compressed by the inside surface on the second cutter 69. In the IC card 200 constructed as described, the cut surface of the plastic material 5 and test terminal 16 is covered by the outer sheath sheet 2 and does not appear on the end surface of the IC card (Fig.9).

In the non-contact type IC card 100 constructed as described, the sheet 1 serves the functions of both a circuit board for mounting electronic parts 4 and an outer sheath of the IC card. Further, the plastic material 5 completely covers the circuit pattern 3 formed on the sheet 1 and the electronic parts mounted thereon, thereby protecting the electronic parts 4 and the circuit pattern 3 and at the same time forming an outer sheath of the IC card 100. Thickness of the IC card 100 may thus be reduced and its strength against an external force is improved.

Further, the outer sheath sheet 2 together with the sheet 1 forms the outer sheath of the IC card which is excellent in water resistance and oil resistance, and the IC card 100 is further improved in strength.

Furthermore, since the electronic part 4 is mounted on the circuit pattern 3 as adhered thereto by means of a conductive adhesive, reliability of the connection thereof is improved.

Moreover, since the non-contact type IC card 100 is cut off at its sides by a cutting edge, the cost may be lowered because the number of component parts is smaller as there is no frame for constituting the sides.

In the method for manufacturing a non-contact type IC card 100 as described, the manufacturing steps are performed in a continuous succession and it is possible to get the manufacturing steps into line and to implement an automation thereof so that fewer manufacturing steps and shorter manufacturing time may be achieved to lower the cost.

Further, the circuit patterr 3 is formed as having a small thickness by printing so that the IC card 100 may be manufactured as having a small thickness.

Furthermore, since the electronic parts 4 are mounted on the circuit pattern 3 by a conductive adhesive, work required in the mounting step becomes simpler and reliability of the connection between the electronic parts and the circuit pattern is improved.

Moreover, the plastic material 5 is formed as it quickly permeates the space among the electronic parts by a uniform force due to a press, whereby the plastic material penetrates into and this the space among the electronic parts to enhance the strength of the IC card 100 and it is possible to reduce time required for the manufacturing steps.

Further, the circuit function may be checked by connecting a test head of a circuit tester to the test terminal 16. The test head may thus be formed as having a simple configuration and checking of the circuit function during the manufacturing steps may be readily performed.

### Comparative example 2

Fig.10 shows a circuit pattern device forming device which is another comparative example of the manufacturing apparatus for the non-contact type IC card. While, in comparative example 1, the formation of a circuit pattern has been performed by the screen printing machine 7 where a conductive ink or conductive paste 9 (such as silver or carbon) is pushed out by means of the roller 7a to form the circuit pattern 3 on the sheet 1, the circuit pattern may also be formed, for example, such that, as shown in Fig.10, a thin gold foil 23 formed on a transfer film 21 is transferred or adhered to the sheet 1 by means of a heating roller 20.

In the method for manufacturing a non-contact type IC card as described above, the circuit pattern is formed as having a small thickness by transfer. The IC card may thus be manufactured as having a small thickness and time required for the work may be reduced.

### Comparative example 3

Fig.11 shows another comparative example of the manufacturing apparatus for the non-contact type IC card where the drying furnace 8 after the circuit pattern device forming device is obliterated. In this comparative example as shown in Fig.11, after printing the circuit pattern 3 by means of a screen printing, the electronic parts 4 are mounted as adhered thereto by pressure by the chip mounter 25 before the circuit pattern 3 is dried and cured. Thereafter, drying/curing is effected at a curing drier 28. By using this method, the drying furnace 8 may be omitted to facilitate the steps in the manufacturing process.

In the non-contact type IC card constructed as described, the electronic parts are mounted onto the circuit pattern 3 by pressure-bonding prior to its curing. Thus, reliability of the connection between the electronic parts 4 and the circuit pattern 3 is improved and a material for connecting the electronic parts 4 and the circuit pattern 3 is not required.

In the above manufacturing method, the electronic parts 4 are mounted on a molten circuit pattern 3 by pressure-bonding, whereby work required in the mounting step is simplified and a material for the connection thereof is not required and reliability of the connection between the electronic parts 4 and the circuit pattern 3 is improved.

### Embodiment

Fig.12 shows an embodiment of the non-contact type IC card in its state of being manufactured. While, in comparative example 1, a plastic material 5 consisting of a thermoplastic prepreg material is used to fill the space between the electronic parts 4, used in this embodiment is a buffer sheet 40 serving as an intermediate layer made of a resin (such as a glass epoxy resin sheet or phenolic resin plate). An adhesive is applied on a back surface of the buffer sheet 40 on which a hole corresponding to the electronic part mounting portion is previously provided. After adhering it onto the circuit pattern 3, the portion of gaps with the electronic parts 4 in the hole is filled with a reactive resin 41 which is a filling resin material (such as an epoxy adhesive) by a filling resin material filling apparatus 42. After adhering the outer sheath sheet 2 thereto, the card is formed as cured by means of a heat by using a heating and pressure-bonding roller 43 which serves as an intermediate layer securing apparatus.

According to this method, since the plastic material 5 of thermoplastic prepreg material is not used, the heater 31 is not necessary and the construction of the manufacturing apparatus is simpler.

In the non-contact type IC card constructed as described, the buffer sheet 40 serving as an intermediate layer, together with the reactive resin 41, completely covers the circuit pattern formed on the sheet and the electronic parts mounted thereon, thereby protecting the electronic parts and the circuit pattern and forming an outer sheath of the IC card. Thus, the strength of the IC card is further improved.

In the above manufacturing method, the manufacturing steps are performed in a continuous succession and it is possible to get the manufacturing steps into line and to implement an automation thereof; in addition, the method is possible without a compressing step. Fewer manufacturing steps and shorter manufacturing time may thus be achieved to lower the cost.

### Comparative example 4

Fig.13 is a sectional view showing another example of non-contact type IC card according to the present invention. Figs.14 to 17 show a manufacturing process of a non-contact type IC card in accordance with the sequence of the process. Referring to Fig.13, a noncontacting IC card 220 has a first sheet 105 and a second sheet 111. A circuit pattern 104a is formed on a surface of the first sheet 105. Further, a circuit pattern 104b is formed on a surface of the second sheet 111.

The first sheet 105 and second sheet 111 are constituted for example by a PET (polyethylene terephthalate) material or by sheets of materials of similar type. The first sheet 105 and second sheet 111 are adhered to each other by an adhesive 106.

Formed on the surface of first sheet 105 and second sheet 111 respectively as a part of the circuit pattern 104a and a part of the circuit pattern 104b are conductive lands 108 and 109 which serve as connection means for electrically connecting the circuit pattern 104a and circuit pattern 104b to each other. The conductive lands 108 and 109 are formed at corresponding positions on the respective surfaces of the first sheet 105 and second sheet 111.

A hole 105a is formed on the upper-side first sheet 105 at a center portion of the conductive land 108 in a manner passing through the conductive land 108 and also through the sheet 105 thereunder. The hole 105a is filled with a conductive resin 107. The conductive resin 107 electrically connects the conductive lands 109 and 108 to each other and thus electrically connects the circuit pattern 104a to the circuit pattern 104b.

The first sheet 105 and second sheet 111 laid upon each other and the circuit patterns 104a, 104b formed on the respective sheets constitute a circuit board 210. Further, the first sheet 105, the circuit patterns 104a, 104b and the conductive resin 107 constitute a circuit pattern device provided on the other surface of the second sheet 111. An electronic part 114 such as a capacitor or IC is mounted on the circuit pattern 104a formed on the first sheet 105 of the circuit board 210. The electronic part 114 is connected to the circuit pattern 104a through a conductive adhesive 115.

A buffer sheet 117 made of a resin serving as an intermediate layer and having a hole previously provided at a portion thereof for mounting electronic parts is placed over the portion of circuit pattern 104a without the electronic part 114 placed thereon. The buffer sheet 117 is constituted for example by the material of a glass epoxy resin sheet or phenol resin plate.

A third sheet 116 is placed upon the buffer sheet 117, and the respective gaps among the circuit board 210, electronic part 114, buffer sheet 117 and third sheet 116 are filled with a reactive resin 118 which is a filling resin material (an epoxy adhesive or the like). The four side surfaces of the IC card 220 are cut off by a cutting edge to result the shape of a standard type IC card.

Figs.14 to 17 show the manufacturing process of the non-contact type IC card 220 in accordance with the sequence of the process. First, as shown in Fig.14, the circuit pattern 104a and circuit pattern 104b are formed on the first sheet 105 and second sheet 111, respectively. In a similar manner as in comparative example 1, the first sheet 105 and second sheet 111 are sequentially supplied from their state of being rolled and advance to a screen printing machine, respectively, and the circuit patterns are formed as printed by the screen printing machine such that a conductive ink or conductive paste (such as silver or carbon) is pushed out onto the sheets by means of a roller.

Next, a hole 105a is formed at a center portion of the conductive land 109 and the adhesive 106 is applied onto the back surface of the first sheet 105.

Next, as shown in Fig. 15, the first sheet 105 and second sheet 111 are adjusted in their position with respect to each other by a register mark (not shown) and are then pressure-bonded by a press to be laid upon each other. Further, as shown in Fig.16, a conductive resin 107 is supplied into and then cured in the hole 105a by printing or dispensing.

It should be noted that the conductive land 108 is formed to have a large size as compared to the hole 105a, whereby it is possible to reduce the problem of conduction defect in the case where the first sheet 105 and second sheet 111 are incorrectly positioned with respect to each other.

Next, as shown in Fig.17, the electronic part 114 such as a capacitor or IC is mounted on the circuit board 210. The electronic part 114 is connected to the circuit pattern 104a through the conductive adhesive 115.

The conductive resin 107 and the conductive adhesive 115 are made of the same material and may be supplied in the same processing step for example by screen printing though it is also possible to supply them separately.

Next, in a similar manner as in the Embodiment, a member obtained as applying an adhesive to the back surface of the buffer sheet 117 which is previously provided with a hole at a portion thereof for mounting electronic parts is adhered to the circuit pattern 104a; then the gap portion with the electronic part 114 in the hole is filled with the reactive resin 118; and, after an outer sheath sheet 116 is adhered thereto, it is formed as cured by a heat using a heating and pressure-bonding roller. Finally, the four side surfaces thereof are cut off to complete the non-contact type IC card 220.

While, in the present comparative example, the buffer sheet 117 serving as an intermediate layer is placed over the portion of circuit pattern 104a without the electronic part 114 mounted thereon, it is also possible similarly as in comparative example 1 to use a plastic material such as a thermoplastic prepreg material to fill the space with the electronic part 114.

While the number of sheets for constructing the circuit board 210 in the present comparative example is two, the number may be increased as required. Further, while the electronic part 114 is not mounted on the conductive resin 107 in the present comparative example, it is possible to mount it thereon as required.

In the noncontacting IC card 220 constructed as described above, since the first sheet 105 and second sheet 111 are laminated and the circuit patterns 104a, 104b are formed on the respective sheets, many circuit patterns including an antenna, etc., may be constructed in a limited space.

### Comparative example 5

Fig.18 is a sectional view of a circuit board showing another example of noncontacting IC card. In this figure, circuit patterns 104a, 104b are provided on the two surfaces of a sheet 105 of a circuit board 211. To achieve an electric conduction between the circuit patterns 104a, 104b respectively provided on the two surfaces, conductive lands 108, 109 are formed at opposite positions on the two surfaces of the sheet 105. A hole 105a is provided through the conductive lands 108, 109. A connecting rod 110 made of Al is tightly inserted into the hole 105a. The connecting rod 110 constitutes the connecting means for electrically connecting the circuit patterns 104a, 104b to each other.

Thereafter, electronic parts (not shown) are mounted onto one or both surfaces of the circuit board 211; a plastic material is then placed thereon similarly as in comparative example or a buffer sheet is placed thereon similarly as in the Embodiment so as to protect the mounted electronic parts; and a second sheet and third sheet are then adhered respectively to further outside of the two surfaces to construct a noncontacting IC card.

In the circuit board constructed as described, since the connecting means for electrically connecting the circuit patterns 104a, 104b is provided by the connecting rod 110 made of Al, a device for filling with the conductive resin 107 is not required.

### Comparative example 6

Fig.19 is a sectional view of a circuit board showing another comparative example of the noncontacting IC card. Figs.20 and 21 show the manufacturing process of the circuit board in accordance with the sequence of the process. Referring to Fig.19, while circuit board 212 is substantially identical to the circuit board 211 described in comparative example 5, one end side of Al rod 110 has a larger diameter than the diameter of the hole 105a and the other end side thereof is flattened.

Figs.20 and 21 show the manufacturing method of the circuit board 212. First, as shown in Fig.20, the hole 105a is bored on a sheet 105 which is formed with circuit patterns 104a, 104b respectively on the both surfaces thereof, at the position where conductive lands 108, 109 are provided for electrically connecting the circuit patterns 104a, 104b to each other.

Next, as shown in Fig.21, the Al rod 110 is tightly inserted into the hole 105a from one side (the lower side as shown in Fig.21) of the sheet 105. The diameter of the rear end of the Al rod 110 is larger than the diameter of the hole so as to attain a sufficient electric conduction. Further, the length of the Al rod 110 is longer than the depth of the hole 105a. Then, the portion extended to the outside of the hole 105a is flattened.

With the circuit board 212 of the present comparative example similarly as in comparative example 5 electronic parts (not shown) are mounted onto one or both surfaces of the circuit board 212; a plastic material is then placed thereon similarly as in comparative example 1 or a buffer sheet is placed thereon similarly as in the Embodiment so as to protect the mounted electronic parts; and a second sheet and third sheet are then adhered respectively to further outside of the two surfaces to construct a noncontacting IC card.

In the circuit board constructed as described above, the reliability of its electric conduction is improved, since: the rear end of the Al rod 110 has a larger diameter than the hole diameter; the Al rod 110 has a length longer than the depth of the hole 105a; and the portion extended to the outside of the hole 105a is flattened.

## Claims

1. A non-contact type IC card (100) comprising:
a first sheet (1) made of a resin, the first sheet having one surface defining an outer sheath of the IC card;
a circuit pattern device including a conductive circuit
pattern (3) provided on the other surface of said first sheet (1); electronic parts (4) mounted on said circuit pattern device; and
an electrically insulating filling resin material (41) for filling a gap;
**characterized by**
an intermediate layer (40) made of a resin and being adhered to said circuit pattern device and having an opening for accommodating said electronic parts (4) therein, wherein said gap to be filled with said electrically insulating filling resin material (41) is formed between said intermediate layer (40) and said electronic parts (4).

2. A non-contact type IC card according to claim 1, further comprising a second sheet (2) as a sheath sheet made of a resin on that surface of said IC card (100) which is opposed to a surface of said IC card (100) having said first sheet (1).

3. A non-contact type IC card according to claim 1, wherein said electronic parts are mounted on said circuit pattern device by a conductive adhesive.

4. A non-contact type IC card according to claim 1, wherein said electronic parts are mounted on said circuit pattern device by pressure-bonding before said circuit pattern of said circuit pattern device formed by printing is cured.

5. A non-contact type IC card according to claim 1, wherein at least two side surfaces 100a of said non-contact type IC card are shaped as cut off by a cutting edge.

6. A non-contact type IC card according to claim 1, wherein said circuit pattern device comprises:
a plurality of electrically insulating sheets laid one upon another;
circuit patterns formed respectively on said plurality of sheets; and
connecting means for electrically connecting said respective circuit patterns to each other.

7. A non-contact type IC card according to claim 1, wherein said circuit pattern devices comprises:
at least one electrically insulating sheet;
circuit patterns formed on the both surfaces of said sheet; and
connecting means for electrically connecting said circuit patterns formed on the both surfaces to each other.

8. A method for manufacturing a non-contact type IC card having a first sheet made of a resin, the first sheet having one surface defining an outer sheath of the IC card (100), said method comprises the steps of:
forming a circuit pattern device including a conductive circuit pattern (3) on the other surface of said first sheet; mounting electronic parts (4) on said circuit pattern device; and
filling a gap with a filling resin material (41) to form an integrated plate-like body;
**characterized by the steps of**
adhering an intermediate layer (40) made of a resin and having an opening for accommodating said electronic parts (4) onto said circuit pattern device, wherein said gap to be filled with said filling resin material (41) is formed between said intermediate layer (40) and said electronic parts (4); and
severing the IC card from the plate-like body having said first sheet and said intermediate layer (40).

9. A method for manufacturing a non-contact type IC card according to claim 8, wherein said step of forming a circuit pattern device comprises the steps of:
laying a plurality of insulating sheets each formed with a circuit pattern one upon another; and
electrically connecting the respective circuit patterns to each other.

10. A method for manufacturing a non-contact type IC card according to claim 8, wherein said step of forming a circuit pattern device comprises the steps of:
forming circuit patterns on both surfaces of an insulating sheet; and
electrically connecting the circuit patterns formed on said both surfaces to each other.

11. A method for manufacturing a non-contact type IC card according to claim 8, further comprising the step of bonding an outer sheath sheet made of a resin onto the surface opposite to said sheet of said IC card prior to said step of severing.

12. A method for manufacturing a non-contact type IC card according to claim 8, wherein said step of forming a circuit pattern device includes a circuit pattern forming step to be performed by printing.

13. A method for manufacturing a non-contact type IC card according to claim 8, wherein said step of forming a circuit pattern device includes a circuit pattern forming step to be performed by transfer.

14. A method form manufacturing a non-contact type IC card according to claim 8, wherein said step of mounting electronic parts comprises a step of mounting said electronic parts on said circuit pattern device by means of a conductive adhesive.

15. A method for manufacturing a non-contact type IC card according to claim 8, wherein said step of mounting electronic parts comprises a step of pressure-bonding said electronic parts to said circuit pattern device prior to curing of said circuit pattern device.

16. A method for manufacturing a non-contact type IC card according to claim 8, wherein said step of compressing a plastic material is performed by means of a press.

17. A method for manufacturing a non-contact type IC card according to claim 8, wherein said step of forming a circuit pattern device comprises the steps of:
forming a test terminal on said circuit pattern device; and
performing a test on circuit function by connecting a circuit tester to said test terminal prior to said step of severing.

18. An apparatus for manufacturing a non-contact type IC card (100) having a first sheet (1) made of a resin, the first sheet having one surface defining an outer sheath of the IC card, said apparatus comprises:
a circuit pattern device forming device for forming a circuit pattern device including a conductive circuit pattern (3) on the other surface of said first sheet;
an electronic part mounting device for mounting electronic parts (4) on said circuit pattern device; and
a filling resin material filling device (42) for filling a gap with a filling resin material (41) to form an integrated plate-like body;
**characterized by**
an intermediate layer adhering device for adhering an intermediate layer (40) made of a resin and having an opening for accommodating said electronic parts (4) onto said circuit pattern device, wherein said gap to be filled with said filling resin material (41) is formed between said intermediate layer (40) and said electronic parts (4); and
a severing device for severing the IC card from the plate-like body.

## Patentansprüche

1. Kontaktlose Chipkarte (100), mit:
einem ersten Blatt (1) aus einem Harz, das (1) eine Oberfläche mit einer äußeren Ummantelung der Chipkarte (100) hat;
einer Schaltungsmustereinrichtung, die über ein leitfähiges Schaltungsmuster (3) auf der äußeren Oberfläche des ersten Blattes (1) verfügt;
elektronischen Teilen (4), die die Schaltungsmustereinrichtung trägt; und mit
einem elektrisch isolierenden Füllharzmaterial (41) zum Ausfüllen eines Spaltes;
**gekennzeichnet durch**
eine aus einem Harz bestehende und an die Schaltungsmustereinrichtung angeklebte Zwischenschicht (40), die mit einer Öffnung zum Aufnehmen der elektronischen Teile (4) versehen ist, wobei der mit dem elektrisch isolierenden Füllharzmaterial (41) auszufüllende Spalt zwischen der Zwischenschicht (40) und den elektronischen Teilen (4) gebildet ist.

2. Kontaktlose Chipkarte nach Anspruch 1, die des weiteren über ein zweites Blatt (2) als Ummantelungsblatt aus einem Harz auf derjenigen Oberfläche der Chipkarte (100) verfügt, die der Oberfläche der Chipkarte (100) mit dem ersten Blatt (1) gegenübersteht.

3. Kontaktlose Chipkarte nach Anspruch 1, deren Schaltungsmustereinrichtung die elektronischen Teile mit einem leitfähigen Kleber trägt.

4. Kontaktlose Chipkarte nach Anspruch 1, deren elektronische Teile auf der Schaltungsmustereinrichtung durch Preßkontaktieren befestigt sind, bevor das durch Drucken gebildete Schaltungsmuster der Schaltungsmustereinrichtung ausgehärtet ist.

5. Kontaktlose Chipkarte nach Anspruch 1, bei der wenigstens zweiseitige Oberflächen (100a) der kontaktlosen Chipkarte durch eine Schnittkante abgeschnitten geformt sind.

6. Kontaktlose Chipkarte nach Anspruch 1, deren Schaltungsmustereinrichtung ausgestattet ist mit:
einer Vielzahl übereinandergelegter elektrisch isolierender Blätter;
Schaltungsmustern, die jeweils auf der Vielzahl von Blättern gebildet sind; und mit
einem Verbindungsmittel zum elektrischen Verbinden der jeweiligen Schaltungsmuster.

7. Kontaktlose Chipkarte nach Anspruch 1, deren Schaltungsmustereinrichtungen ausgestattet sind mit:
wenigstens einem elektrisch isolierenden Blatt;
Schaltungsmustern, die auf beiden Oberflächen des Blattes gebildet sind; und mit
einem Verbindungsmittel zum elektrischen Verbinden der auf beiden Oberflächen gebildeten Schaltungsmuster.

8. Verfahren zum Herstellen einer kontaktlosen Chipkarte mit einem ersten Blatt aus Harz, das eine Oberfläche hat, die eine äußere Ummantelung der Chipkarte (100) festlegt, mit den Verfahrensschritten:
Bilden einer Schaltungsmustereinrichtung, die über ein leitfähiges Schaltungsmuster (3) auf der äußeren Oberfläche des ersten Blattes verfügt;
Befestigen elektronischer Teile (4) auf der Schaltungsmustereinrichtung; und
Ausfüllen eines Spaltes mit einem Füllharzmaterial (41), um einen integrierten plattenförmigen Körper zu bilden;
**gekennzeichnet durch** die Verfahrensschritte:
Kleben einer Zwischenschicht (40) aus einem Harz und mit einer Öffnung zum Aufnehmen der elektronischen Teile (4) auf die Schaltungsmustereinrichtung, wobei der mit dem Füllharzmaterial (41) auszufüllende Spalt zwischen der Zwischenschicht (40) und den elektronischen Teilen (4) gebildet ist; und
Trennen der Chipkarte vom plattenförmigen Körper mit dem ersten Blatt und der Zwischenschicht (40).

9. Verfahren zur Herstellung einer kontaktlosen Chipkarte nach Anspruch 8, bei dem der Verfahrensschritt des Bildens einer Schaltungsmustereinrichtung die Verfahrensschritte umfaßt:
Legen einer Vielzahl von jeweils mit einem Schaltungsmuster gebildeten Isolationsschichten übereinander; und
Herstellen einer elektrischen Verbindung zwischen den jeweiligen Schaltungsmustern.

10. Verfahren zur Herstellung einer kontaktlosen Chipkarte nach Anspruch 8, bei dem der Verfahrensschritt des Bildens einer Schaltungsmustereinrichtung die Verfahrensschritte umfaßt:
Bilden von Schaltungsmustern auf beiden Oberflächen eines Isolationsblattes; und
Herstellen einer elektrischen Verbindung zwischen den auf beiden Oberflächen gebildeten Schaltungsmustern.

11. Verfahren zur Herstellung einer kontaktlosen Chipkarte nach Anspruch 8, das des weiteren den Verfahrensschritt des Kontaktierens eines äußeren Mantelblattes aus einem Harz auf die Oberfläche beinhaltet, die dem Blatt der Chipkarte vor dem Verfahrensschritt des Trennens gegenübersteht.

12. Verfahren zur Herstellung einer kontaktlosen Chipkarte nach Anspruch 8, bei dem der Verfahrensschritt des Bildens einer Schaltungsmustereinrichtung einen Verfahrensschritt des Bildens eines durch Drucken auszuführenden Schaltungsmusters umfaßt.

13. Verfahren zur Herstellung einer kontaktlosen Chipkarte nach Anspruch 8, bei dem des Verfahrensschritt des Bildens einer Schaltungsmustereinrichtung einen Verfahrensschritt des Bildens eines durch Übertragen auszuführenden Schaltungsmusters enthält.

14. Verfahren zur Herstellung einer kontaktlosen Chipkarte nach Anspruch 8, bei dem der Verfahrensschritt des Befestigens elektronischer Teile einen Verfahrensschritt des Befestigens der elektronischen Teile auf der Schaltungsmustereinrichtung mit einem leitfähigen Klebstoffs umfaßt.

15. Verfahren zur Herstellung einer kontaktlosen Chipkarte nach Anspruch 8, bei dem der Verfahrensschritt des Befestigens elektronischer Teile einen Verfahrensschritt des Preßkontaktierens der elektronischen Teile auf die Schaltungsmustereinrichtung vor Aushärten der Schaltungsmustereinrichtung umfaßt.

16. Verfahren zur Herstellung einer kontaktlosen Chipkarte nach Anspruch 8, bei dem der Verfahrensschritt des Komprimierens eines Plastikmaterials mit einer Presse erfolgt.

17. Verfahren zur Herstellung einer kontaktlosen Chipkarte nach Anspruch 8, bei dem der Verfahrensschritt des Bildens einer Schaltungsmustereinrichtung die Verfahrensschritte umfaßt:
Bilden eines Testanschlusses auf der Schaltungsmustereinrichtung; und
Ausführen eines Tests bezüglich der Schaltungsfunktion durch Anschließen eines Schaltungstesters an den Testanschluß vor dem Verfahrensschritt des Trennens.

18. Gerät zur Herstellung einer kontaktlosen Chipkarte (100) mit einem ersten Blatt (1) aus Harz, das eine Oberfläche hat, die eine äußere Ummantelung der Chipkarte festlegt, mit:
einer Erzeugungseinrichtung für eine Schaltungsmustereinrichtung zum Herstellen einer Schaltungsmustereinrichtung, die über ein leitfähiges Muster (3) auf der anderen Oberfläche des ersten Blattes verfügt;
einer Elektronikteilmontiereinrichtung zum Montieren elektronischer Teile (4) auf die Schaltungsmustereinrichtung; und mit
einer Füllharzmaterialfülleinrichtung (42) zum Ausfüllen eines Spaltes mit einem Füllhartmaterial (41), um einen integrierten plattenförmigen Körper zu bilden;
**gekennzeichnet durch**
eine Zwischenschichtklebeeinrichtung zum Kleben einer Zwischenschicht (40) aus einem Harz mit einer Öffnung zum Aufnehmen der elektronischen Teile 84) auf der Schaltungsmustereinrichtung, wobei der mit dem Füllharzmaterial (41) auszufüllende Spalt zwischen der Zwischenschicht (40) und den elektronischen Teilen (4) gebildet ist; und **durch**
eine Trenneinrichtung, die die Chipkarte vom plattenförmigen Körper trennt.

## Revendications

1. Une carte à circuit intégré (100) du type sans contact, comprenant :
une première feuille (1) constituée d'une résine, la première feuille ayant une surface définissant une gaine extérieure de la carte à circuit imprimé;
une structure de motif de circuit, incluant un motif de circuit conducteur (3) formé sur l'autre surface de la première feuille (1);
des composants électroniques (4) montés sur la structure de motif de circuit; et
une matière consistant en une résine de remplissage électriquement isolante (41) pour remplir un espace;
**caractérisée par**
une couche intermédiaire (40) constituée d'une résine et étant collée sur la structure de motif de circuit et ayant une ouverture pour recevoir à l'intérieur les composants électroniques (4), l'espace à remplir avec la matière consistant en résine de remplissage électriquement isolante (41) étant formé entre la couche intermédiaire (40) et les composants électroniques (4).

2. Une carte à circuit intégré du type sans contact selon la revendication 1, comprenant en outre une seconde feuille (2) à titre de feuille de gaine constituée d'une résine, sur la surface de la carte à circuit intégré (100) qui est opposée à une surface de la carte à circuit intégré (100) ayant la première feuille (1).

3. Une carte à circuit intégré du type sans contact selon la revendication 1, dans laquelle les composants électroniques sont montés au moyen d'un adhésif conducteur sur la structure de motif de circuit.

4. Une carte à circuit intégré du type sans contact selon la revendication 1, dans laquelle les composants électroniques sont montés sur la structure de motif de circuit par soudage par pression avant que le motif de circuit de la structure de motif de circuit formé par impression soit soumis à une opération de maturation.

5. Une carte à circuit intégré du type sans contact selon la revendication 1, dans laquelle au moins deux surfaces latérales (100a) de la carte à circuit intégré du type sans contact ont une forme obtenue par découpage par une lame coupante.

6. Une carte à circuit intégré du type sans contact selon la revendication 1, dans laquelle la structure de motif de circuit comprend :
une multiplicité de feuilles électriquement isolantes placées les unes sur les autres;
des motifs de circuit formés respectivement sur la multiplicité de feuilles; et
des moyens de connexion pour connecter électriquement les motifs de circuit respectifs les uns aux autres.

7. Une carte à circuit intégré du type sans contact selon la revendication 1, dans laquelle la structure de motif de circuit comprend :
au moins une feuille électriquement isolante;
des motifs de circuit formés sur les deux surfaces de cette feuille; et
des moyens de connexion pour connecter électriquement mutuellement les motifs de circuit formés sur les deux surfaces.

8. Un procédé pour fabriquer une carte à circuit intégré du type sans contact ayant une première feuille constituée d'une résine, la première feuille ayant une surface définissant une gaine extérieure de la carte à circuit intégré (100), ce procédé comprenant les étapes suivantes; on forme une structure de motif de circuit, incluant un motif de circuit conducteur (3), sur l'autre surface de la première feuille;
on monte des composants électroniques (4) sur la structure de motif de circuit; et
on remplit un espace avec une matière consistant en résine de remplissage (41), pour former un corps d'un seul tenant semblable à une plaquette;
**caractérisé par** les étapes suivantes :
on fait adhérer sur la structure de motif de circuit une couche intermédiaire (40) constituée d'une résine et ayant une ouverture pour recevoir les composants électroniques (4), l'espace à remplir avec la matière consistant en résine de remplissage (41) étant formé entre la couche intermédiaire (40) et les composants électroniques (4); et
on découpe la carte à circuit intégré de façon à la séparer du corps semblable à une plaquette ayant la première feuille et la couche intermédiaire (40).

9. Un procédé pour fabriquer une carte à circuit intégré du type sans contact selon la revendication 8, dans lequel l'étape de formation d'une structure de motif de circuit comprend les étapes suivantes :
on stratifie les unes sur les autres une multiplicité de feuilles isolantes portant chacune un motif de circuit; et
on connecte électriquement les motifs de circuit respectifs les uns aux autres.

10. Un procédé pour fabriquer une carte à circuit intégré du type sans contact selon la revendication 8, dans lequel l'étape de formation d'une structure de motif de circuit comprend les étapes suivantes :
on forme des motifs de circuit sur les deux surfaces d'une feuille isolante; et
on connecte électriquement mutuellement les motifs de circuit formés sur les deux surfaces.

11. Un procédé pour fabriquer une carte à circuit intégré du type sans contact selon la revendication 8, comprenant en outre l'étape consistant à fixer une feuille de gaine extérieure, constituée d'une résine, sur la surface opposée à la feuille précitée de la carte de circuit intégré, avant l'étape de découpage.

12. Un procédé pour fabriquer une carte à circuit intégré du type sans contact selon la revendication 8, dans lequel l'étape de formation d'une structure de motif de circuit comprend une étape de formation de motif de circuit qui est effectuée par impression.

13. Un procédé pour fabriquer une carte à circuit intégré du type sans contact selon la revendication 8, dans lequel l'étape de formation d'une structure de motif de circuit comprend une étape de formation de motif de circuit qui est effectuée par transfert.

14. Un procédé pour fabriquer une carte à circuit intégré du type sans contact selon la revendication 8, dans lequel l'étape de montage de composants électroniques comprend une étape de montage des composants électroniques sur la structure de motif de circuit au moyen d'un adhésif conducteur.

15. Un procédé pour fabriquer une carte à circuit intégré du type sans contact selon la revendication 8, dans lequel l'étape de montage de composants électroniques comprend une étape de soudage par pression des composants électroniques sur la structure de motif de circuit, avant la maturation de la structure de motif de circuit.

16. Un procédé pour fabriquer une carte à circuit intégré du type sans contact selon la revendication 8, dans lequel l'étape de compression d'une matière plastique est effectuée au moyen d'une presse.

17. Un procédé pour fabriquer une carte à circuit intégré du type sans contact selon la revendication 8, dans lequel l'étape de formation d'une structure de motif de circuit comprend les étapes suivantes :
on forme une borne de test sur la structure de motif de circuit; et
on effectue un test sur le fonctionnement du circuit en connectant un testeur de circuit à la borne de test avant l'étape de découpage.

18. Un appareil pour fabriquer une carte à circuit intégré (100) du type sans contact, ayant une première feuille (1) constituée d'une résine, la première feuille ayant une surface définissant une gaine extérieure de la carte à circuit intégré, cet appareil comprenant :
un dispositif de formation de structure de motif de circuit pour former une structure de motif de circuit, incluant un motif de circuit conducteur (3) sur l'autre surface de la première feuille;
un dispositif de montage de composants électroniques pour monter des composants électroniques (4) sur la structure de motif de circuit; et
un dispositif de remplissage (42) avec une matière consistant en résine de remplissage, pour remplir un espace avec une matière consistant en résine de remplissage (41), pour former un corps d'un seul tenant semblable à une plaquette;
**caractérisé par**
un dispositif de collage de couche intermédiaire pour faire adhérer, sur la structure de motif de circuit, une couche intermédiaire (40) constituée d'une résine et ayant une ouverture pour recevoir les composants électroniques (4), l'espace à remplir avec la matière consistant en résine de remplissage (41) étant formé entre la couche intermédiaire (40) et les composants électroniques (4); et
un dispositif de découpage pour découper et séparer la carte à circuit intégré du corps semblable à une plaquette.
